(19) Europäisches Patentamt
European Patent Office
Office européen des brevets

(11) **EP 2 856 588 B1**

(12) **FASCICULE DE BREVET EUROPEEN**

(45) Date de publication et mention
de la délivrance du brevet:
**28.03.2018 Bulletin 2018/13**

(51) Int Cl.:
*H01S 5/40* *(2006.01)*          *H01S 5/10* *(2006.01)*
*H01S 5/34* *(2006.01)*

(21) Numéro de dépôt: **13725619.4**

(22) Date de dépôt: **23.05.2013**

(86) Numéro de dépôt international:
**PCT/EP2013/060667**

(87) Numéro de publication internationale:
**WO 2013/174945 (28.11.2013 Gazette 2013/48)**

(54) **LASER SEMICONDUCTEUR OPTIMISE**

OPTIMIERTER HALBLEITER LASER

OPTIMIZED SEMICONDUCTOR LASER

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **25.05.2012 FR 1201499**

(43) Date de publication de la demande:
**08.04.2015 Bulletin 2015/15**

(73) Titulaire: **THALES**
**92400 Courbevoie (FR)**

(72) Inventeurs:
• **DE NAUROIS, Guy-Maël**
**78300 POISSY (FR)**
• **CARRAS, Mathieu**
**F-94250 Gentilly (FR)**

(74) Mandataire: **Joubert, Cécile et al
Marks & Clerk France
Counseils en Propriete Industrielle
Immeuble "Visium"
22, avenue Aristide Briand
94117 Arcueil Cedex (FR)**

(56) Documents cités:
**US-A- 4 694 459     US-A- 4 722 089
US-A- 4 751 711**

• **DE NAUROIS G M ET AL: "Coherent quantum
cascade laser micro-stripe arrays", AIP
ADVANCES AMERICAN INSTITUTE OF PHYSICS
USA, vol. 1, no. 3, 22 septembre 2011 (2011-09-22),
XP002692624, cité dans la demande**

EP 2 856 588 B1

## Description

### DOMAINE DE L'INVENTION

La présente invention concerne le domaine des lasers semiconducteurs, et plus particulièrement des dispositifs de lasers semiconducteurs en réseau spatialement cohérents émettant un faisceau optique de puissance dans l'infrarouge, proche (longueurs d'onde comprises entre 0.8 $\mu$m et 3 $\mu$m), moyen (3 $\mu$m à 10 $\mu$m) ou lointain (10 $\mu$m à 300 $\mu$m).

La présente invention s'applique notamment aux dispositifs de diodes lasers en réseau et aux dispositifs de lasers à cascade quantique en réseau dénommés selon l'acronyme QCL pour « Quantum Cascade Laser » en langue anglaise.

### ETAT DE LA TECHNIQUE

Le besoin de puissance dans le domaine infrarouge est actuellement satisfait par l'utilisation de sources lasers à gaz, tel que le $CO_2$, ou des sources à conversion de fréquence. Mais ces lasers sont encombrants, présentent un coût élevé, sont peu robustes et possèdent un faible rendement et donc une consommation élevée.

A partir de lasers semiconducteurs, la solution la plus simple pour obtenir de la puissance est d'utiliser des structures émettrices larges, mais cela conduit à des faisceaux émis qui n'ont pas une bonne qualité optique. Une solution est la réalisation d'une large structure active comprenant un réseau de plusieurs émetteurs émettant en phase, ce qui signifie que les différents émetteurs sont spatialement cohérents entre eux.

Un premier exemple de dispositif de lasers semiconducteurs en réseau est obtenu à partir de diodes laser. Cette structure comprend une structure active continue et planaire comprenant une fine zone de gain, typiquement de quelques nm à quelques dizaines de nm, elle-même comprenant un empilement de quelques couches semiconductrices formant des puits quantiques (par exemple AlGaAS/GaAs, ou InGaAs/InP). Ces structures émettent un faisceau optique de longueur d'onde typiquement comprise entre 0.8 $\mu$m et 3 $\mu$m.

La structure active est disposée entre deux couches réalisant un confinement de l'onde optique dans la direction verticale perpendiculaire au plan de la structure active. La structuration de la couche active en différents émetteurs s'effectue perpendiculairement à la direction de propagation, selon une direction latérale.

L'indice de réfraction est rendu périodique latéralement dans l'une des couches par gravure, ce qui conduit à un confinement latéral de l'onde optique et à une pluralité d'émetteurs répartis selon la périodicité de l'indice. Le mode de gravure standard grave partiellement la zone active et est dénommé « shallow etching » en langue anglaise.

Un inconvénient de ces structures est que les émetteurs sont faiblement couplés, et que cela n'apporte pas d'amélioration thermique. Un autre inconvénient est que l'émission cohérente présente en général plusieurs lobes, c'est-à-dire que le laser émet plusieurs faisceaux de directions différentes. Cela nuit à la brillance du laser, et de façon générale à la qualité optique (mesurée par le paramètre $M^2$).

Dans les années 80, une structuration dans le plan de la couche supérieure, dénommé jonction Y, a permis d'obtenir une propagation dans le dispositif en réseau du mode fondamental, et ainsi une émission laser sur ce mode (US 4866724). Un inconvénient est que cette approche ne maximise pas la puissance émise.

Un second exemple de dispositif de lasers semiconducteurs en réseau est obtenu à partir de lasers à cascade quantique dénommés QCL pour « Quantum Cascade Laser » en anglais. Ces lasers émettent un faisceau optique de longueur d'onde comprise entre 3 $\mu$m et 300 $\mu$m.

Un laser à cascade quantique comprend une structure active comprenant un empilement de plusieurs centaines à plusieurs milliers de couches réalisant une alternance de couches définissant un puits quantique et de couches définissant une barrière quantique. La structure active est située entre deux structures réalisant une fonction de guidage de l'onde optique et d'injection des porteurs.

Par exemple, la structure active comprend une alternance de AlInAs et de GaInAs et présente une épaisseur comprise entre 1$\mu$m et 3 $\mu$m.

Pour obtenir de la puissance à partir d'un seul laser QCL, la solution la plus simple est d'utiliser une structure large. Cette solution n'est pas satisfaisante pour des considérations de qualité optique du faisceau émis (filamentation, multi-modicité), et également, dans le cas des QCL, pour des considérations thermiques.

Afin de conserver une bonne qualité de faisceau, les lasers QCL de puissance actuels sont donc limités à une cavité étroite. Un exemple est un laser QCL utilisant une cavité de 8 $\mu$m, émettant à une longueur d'onde de 4.6 $\mu$m et délivrant une puissance continue de 5W.

Pour l'obtention de puissance optique, une solution est comme précédemment de créer une large structure active, comprenant un réseau de plusieurs émetteurs émettant en phase, ce qui signifie que les différents émetteurs sont spatialement cohérents. Cela permet de dissiper la chaleur latéralement, de manière similaire à un « radiateur » et de contrôler la qualité du faisceau du fait du réseau ainsi crée. La structuration de l'émetteur est généralement périodique perpendiculairement à la direction de propagation. Les réseaux ont permis d'apporter une solution à la qualité de faisceau des lasers larges.

Comme précédemment, un inconvénient de ces dispositifs est que l'émission cohérente présente en général plusieurs lobes, c'est-à-dire que le laser émet plusieurs faisceaux de directions différentes. Cela nuit à la brillance du laser, et de façon générale à la qualité optique (mesurée par le paramètre $M^2$).

US4722089 divulgue un réseau de lasers semiconducteurs couplés par ondes évanescentes de manière à ce que l'émission ne présente qu'un seul lobe. Récemment, un dispositif de lasers QCL en réseau spatialement cohérents entre eux a été réalisé par couplage évanescent (G.M. de Naurois, M. carras, B.Smozrag, O. Patard, F. Alexandre, et X. Marcadet, « Cohérent quantum cascade laser micro-stripe arrays », AIP Advances 1, 032165 ,2011). Ce dispositif comprend des émetteurs discrets sous forme de rubans étroits et parallèles, séparés d'une distance inférieure à 1.5 fois la longueur d'onde d'émission. Chaque ruban comprend une structure active, la structure active étant disposée entre deux structures guidantes et injectrices. Dans ce cas, le laser émet sur un mode dénommé mode asymétrique, qui présente en champ lointain deux lobes correspondant à deux directions de faisceau. Il présente l'inconvénient de ne pas laser selon un lobe unique.

Un but de l'invention est de palier à l'inconvénient précité, en proposant un dispositif laser comprenant des lasers semiconducteurs en réseau spatialement cohérents émettant selon le mode fondamental qui ne comprend qu'un seul lobe d'émission.

DESCRIPTION DE L'INVENTION

La présente invention a pour objet un dispositif comprenant une pluralité de lasers semi-conducteurs à cascade quantique en réseau spatialement cohérents, comprenant :

-    une pluralité de structures actives disposées selon un plan Oxy et comprenant au moins une couche à gain apte à générer une onde optique présentant au moins une longueur d'onde d'émission et destinée à émettre lorsque des porteurs de charges sont injectés dans lesdites structures actives,
-    chaque structure active comprenant un empilement de plusieurs centaines à plusieurs milliers de couches réalisant une alternance de couches définissant un puits quantique et de couches définissant une barrière quantique,
-    chaque structure active étant disposée entre une structure supérieure et une structure inférieure déposée sur un substrat,
-    lesdites structures supérieure et inférieure étant adaptées pour permettre l'injection de porteurs de charges dans lesdites structures actives et le confinement de ladite onde optique dans ledit plan Oxy et, - ledit dispositif comprenant une pluralité de rubans formant guides optiques et définis par au moins une structure active, lesdits rubans étant parallèles entre eux selon une direction d'alignement y comprise dans ledit plan Oxy, et,
-    un matériau intermédiaire occupe des zones intermédiaires (64, 84, 94, 104) entre deux rubans (10), ledit matériau intermédiaire présentant une conductivité thermique supérieure à la conductivité thermique d'une structure active, ledit dispositif étant tel que :

-    chaque ruban comprend au moins une première extrémité en forme de pointe,
-    ladite pluralité de rubans est agencée selon au moins un premier ensemble de rubans et au moins un deuxième ensemble de rubans
-    deux rubans successifs d'un même ensemble sont espacés d'une distance de séparation constante inférieure ou égale à ladite longueur d'onde d'émission,
-    lesdites extrémités en pointe des rubans du premier ensemble étant orientées dans le sens opposé à celui desdites extrémités en pointe des rubans du deuxième ensemble et pénétrant entre les extrémités en pointes des rubans du deuxième ensemble sur une distance de pénétration définissant une première zone de couplage par laquelle un mode fondamental de l'onde optique est transmis par couplage du premier ensemble de rubans au deuxième ensemble de rubans.

Avantageusement deux rubans successifs appartenant respectivement audit premier ensemble et audit deuxième ensemble sont espacés d'une distance de décalage constante sensiblement égale à la moitié de ladite distance de séparation.

Avantageusement, lesdits rubans du deuxième ensemble comprennent une deuxième extrémité en forme de pointe coopérant avec des extrémités en forme de pointe de rubans d'un troisième ensemble de rubans de la même manière que les extrémités des rubans du premier ensemble coopèrent avec les extrémités des rubans du deuxième ensemble, lesdites extrémités réalisant une deuxième zone de couplage dans laquelle ledit mode fondamental de l'onde optique est transmis par couplage du deuxième ensemble de rubans au troisième ensemble de rubans.

Avantageusement le dispositif comprend une série de N ensembles de rubans ayant chacun des extrémités en forme de pointe coopérant avec des extrémités en forme de pointe d'un autre ensemble pour définir des zones de couplage entre chaque ensemble.

Avantageusement, la structure inférieure et la structure supérieure sont continues et disposées respectivement en dessous et au dessus des structures actives.

Avantageusement chaque ruban est défini par un empilement comprenant une structure active et une structure supérieure.

Avantageusement, chaque ruban est défini par un empilement comprenant une structure inférieure, une structure active et une structure supérieure.

Avantageusement la structure active comprend un empilement de couches actives, deux couches actives étant séparées par une couche de séparation présentant une conductivité thermique supérieure à la conductivité thermique d'une couche active.

D'autres caractéristiques, buts et avantages de la présente invention apparaîtront à la lecture de la description détaillée qui va suivre et en regard des dessins annexés, données à titre d'exemple non limitatifs et sur lesquels :

- la figure 1 décrit un dispositif laser selon l'invention vu de dessus,
- la figure 2 décrit une variante préférée de l'invention,
- la figure 3a représente la distribution de champ et la distribution d'énergie associée à l'émission de deux émetteurs émettant en phase selon le mode antisymétrique,
- la figure 3b représente la distribution de champ et la distribution d'énergie associée à l'émission de deux émetteurs émettant en phase selon le mode symétrique,
- la figure 4 décrit un exemple de simulation de l'évolution du coefficient de transmission du mode fondamental en fonction de la longueur des pointes d'un dispositif selon l'invention,
- la figure 5 décrit un exemple de simulation de l'évolution du coefficient de transmission du mode asymétrique fondamental en fonction de la longueur des pointes d'un dispositif selon l'invention,
- la figure 6 décrit un mode de réalisation du dispositif selon l'invention vu en coupe selon le plan Oxz, où chaque ruban est défini par une structure active,
- la figure 7 illustre schématiquement un exemple de procédé de fabrication du dispositif laser selon l'invention décrit figure 6, le dispositif étant vu en coupe selon le plan Oxz.
- la figure 8 décrit un autre mode de réalisation du dispositif dans lequel le dispositif comprend une pluralité d'empilements comprenant une structure active et une structure supérieure, chaque ruban étant défini par un empilement,
- la figure 9 décrit un autre mode de réalisation du dispositif dans lequel le dispositif comprend une pluralité d'empilements comprenant une structure inférieure, une structure active et une structure supérieure, chaque ruban étant défini par un empilement,
- la figure 10 décrit un mode de réalisation de l'invention où la structure active est multicouche.

## DESCRIPTION DETAILLEE DE L'INVENTION

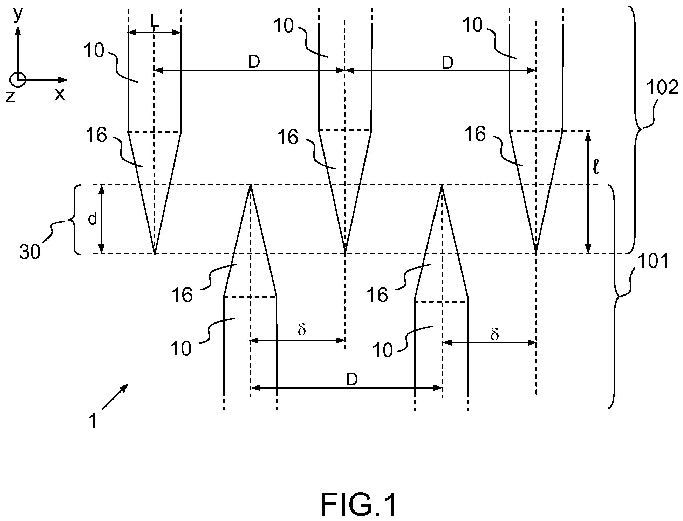

La figure 1 décrit un dispositif laser selon l'invention comprenant des lasers semiconducteurs à cascade quantique en réseau spatialement cohérents entre eux vu de dessus.

Le dispositif laser 1 comprend au moins un pluralité de structures actives disposée selon un plan Oxy, parallèle entre elles selon une direction d'alignement y comprise dans le plan Oxy, une structure active comprenant au moins une couche à gain apte à générer une onde optique présentant au moins une longueur d'onde d'émission $\lambda$, et destinée à émettre une onde lumineuse de type laser lorsque des porteurs sont injectés dans la structure active.

La structure active d'un laser à cascade quantique (QCL) comprend un empilement de plusieurs dizaines à plusieurs centaines de couches réalisant une alternance de couches définissant un puits quantique et de couches définissant une barrière quantique. Ces lasers présentent des longueurs d'onde d'émission comprises dans la l'infrarouge moyen ou lointain.

Un exemple de laser semiconducteur à cacade quantique selon l'invention comprend un structure active comportant un empilement de plusieurs milliers de couches alternant GaInAs (puits) et AlInAs (barrière), des couches inférieures et supérieures en InP dopé, par exemple dopé Si (InP :Si), la couche inférieure étant déposée sur un substrat en InP.

A titre d'exemple, l'épaisseur de la structure active est comprise entre 1 $\mu$m et 3 $\mu$m, et l'épaisseur des couches inférieure et supérieure est de quelques $\mu$m.

D'autres lasers à cascade quantique sont par exemple réalisés sur un substrat AsGa.

La structure active est disposée entre une structure supérieure et une structure inférieure déposée sur un substrat.

Les structures supérieures et inférieures ont deux fonctions principales. Une fonction d'injection de porteurs de charges dans la structure active et une fonction de confinement de l'onde optique dans le plan Oxy. Par exemple, ces structures présentent un indice de réfraction inférieur à l'indice de réfraction de la structure active de manière à réaliser une fonction guidante de l'onde optique générée afin qu'elle se propage selon une direction de propagation comprise dans ledit plan Oxy.

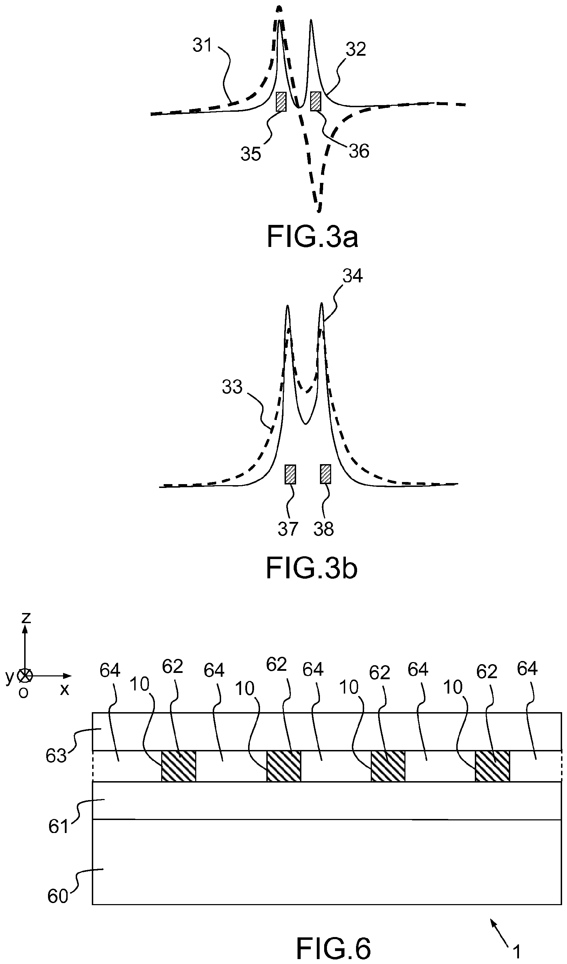

Le dispositif 1 selon l'invention comprend une pluralité de rubans 10 parallèles entre eux selon une direction d'alignement y comprise dans le plan Oxy, et formant guide d'onde. Les rubans sont définis par au moins une structure active. Cela signifie que les rubans ont une forme définie par la structure active, ou définie par un empilement comprenant la structure active et au moins une autre structure, supérieure et/ou inférieur, comme décrit plus bas sur les figures 6, 8 et 9.

Du fait de la fonction guidante des rubans, l'onde optique générée se propage dans les rubans selon une direction de propagation parallèle à la direction des rubans y.

Préférentiellement les rubans sont étroits, c'est-à-dire de largeur La faible par rapport à la longueur d'onde d'émission $\lambda$, par exemple d'un facteur supérieur ou égal 2, préférentiellement à 4 :

$$La \leq \lambda/2, \text{ préférentiellement } La \leq \lambda/4.$$

Dans les lasers à cascade quantique, l'évacuation de la chaleur et constitue un problème majeur. Afin de la résoudre, un matériau intermédiaire occupe des zones intermédiaires entre deux rubans 10, soit entre deux zones actives, ce matériau intermédiaire présentant une conductivité thermique supérieure à la conductivité thermique d'une structure active. La zone active est dite « enterrée ».

Les rubans selon l'invention ont une forme spécifique et sont agencés d'une manière particulière afin de permettre la sélection et la propagation du mode optique fondamental dans le dispositif.

Chaque ruban 10 comprend au moins une première extrémité 16 en forme de pointe.

Les rubans 10 sont agencés selon au moins un premier ensemble de rubans 101 et au moins un deuxième ensemble de rubans 102.

Deux rubans successifs d'un même ensemble sont espacés d'une distance de séparation D constante et inférieure ou égale à la longueur d'onde d'émission λ :

$$D \leq \lambda.$$

Les extrémités en pointe 16 des rubans 10 du premier ensemble 101 sont orientées en sens opposé par rapport aux extrémités 16 des rubans 10 du deuxième ensemble 102 et pénètrent entre les extrémités en pointe 16 des rubans du deuxième ensemble 102 sur une distance de pénétration d. Les extrémités des rubans du premier et du deuxième ensemble sont donc tête-bêche et interdigitées.

La distance de pénétration d définit une zone de couplage 30 qui correspond à une bande de recouvrement où à la fois une partie des extrémités des rubans du premier ensemble et une partie des extrémités du ruban du deuxième ensemble sont présentes.

La forme et l'agencement de ces extrémités en pointe définissent la zone de couplage 30 dans laquelle le mode optique fondamental, dénommé également mode symétrique, est transmis par couplage du premier ensemble de rubans 101 au deuxième ensemble de rubans 102, comme expliqué plus loin.

La distance de pénétration d est comprise entre 0% et 100% de la longueur l de l'extrémité 16, avantageusement entre 30% et 100%.

La forme en pointe et l'agencement inter digité de ces pointes des rubans des lasers en réseau selon l'invention réalise une propagation sélective du mode fondamental au détriment des autres modes, opérant ainsi un filtrage au profit du seul mode fondamental.

Les rubans du deuxième ensemble 102 sont décalés par rapport aux rubans du premier ensemble 101 d'une distance de décalage δ selon une direction x perpendiculaire à la direction d'alignement y, y étant égale à la direction de propagation de l'onde optique. Un fonctionnement optimum correspondant à une onde se propageant sensiblement symétriquement par rapport à l'axe de la pointe est obtenu pour une distance de décalage δ égale à la moitié de la distance de séparation D soit :

$$\delta = D/2$$

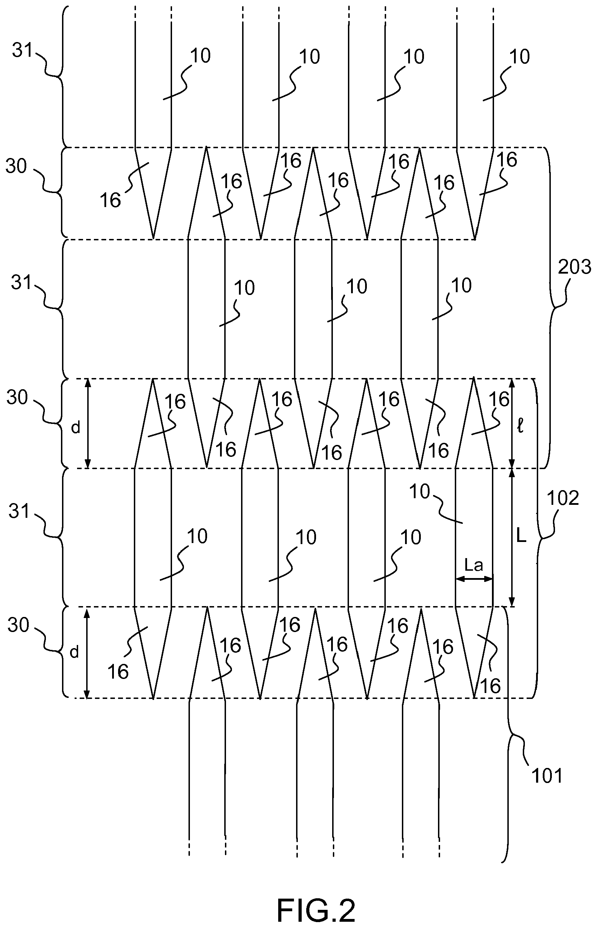

La figure 2 décrit une variante préférée de l'invention, où la distance de pénétration d entre est égale à la longueur l de l'extrémité 16. Le recouvrement des extrémités en pointes inter digitées est dans ce cas total. Un avantage du recouvrement total est de réaliser un meilleur couplage entre les rubans du premier ensemble et les rubans du deuxième ensemble.

Selon une variante préférée de l'invention également décrite figure 2, les rubans 10 du deuxième ensemble 102 comprennent une deuxième extrémité 16 en forme de pointe qui coopèrent avec des extrémités 16 en forme de pointe de rubans d'un troisième ensemble de rubans 103 de la même manière que les extrémités des rubans du premier ensemble 101 coopèrent avec les extrémités des rubans du deuxième ensemble 102. Les extrémités tête-bêche du deuxième ensemble 102 et troisième ensemble 103 102 réalisent une deuxième zone de couplage 30, dans laquelle le mode fondamental de l'onde optique est transmis par couplage du deuxième ensemble de rubans 102 au troisième ensemble de rubans 103, de la même façon qu'il est transmis du premier ensemble au deuxième ensemble. Avantageusement, on peut ainsi réaliser une série de N ensemble de rubans ayant chacun des extrémités en forme de pointe, ces extrémités coopérant avec des extrémités en forme de pointe d'un autre ensemble pour définir des zones de couplages entre chaque ensemble. Le mode fondamental se transmet successivement d'un ensemble à l'ensemble suivant via les zones de couplage 30.

Les zones 31 situées en dehors des zones de couplage 30 et correspondant à des parties rectangulaires des rubans, sont dénommées zone de propagation. Dans ces zones, le mode optique se propage de manière classique.

Nous allons à présent expliquer pourquoi l'agencement des rubans selon l'invention permet une sélection du mode fondamental au détriment des autres modes.

Dans le cas de l'état de la technique, le dispositif en réseau comprend N rubans étroits et parallèles entre eux, séparés d'une distance D. Les modes de cette structure sont des combinaisons linéaires de N modes élémentaires des rubans individuels. Il existe N combinaisons possibles, créant ainsi N modes, également dénommé supermodes, afin de distinguer les modes des émetteurs individuels et le supermode du dispositif en réseau.

La figure 3a représente la distribution de champ sur la courbe 31, et la distribution d'énergie sur la courbe 32 associées à l'émission de deux émetteurs 35 et 36 parmi les N, émettant en phase selon le mode antisymétrique. Ce mode est défini par une distribution de champs ou les maximas sont de signe alternés (+-+-+-+). Ce mode présente donc N-1 noeuds de champ entre les N émetteurs. Ce mode est celui qui a le plus de gain, du fait de la symétrie du dispositif comprenant ces N rubans parallèles, et donc ce mode est celui sur lequel le dispositif, comprenant N émetteurs rubans, émettra. Cette émission selon l'état de la technique est monomode (seul ce mode asymétrique laser) et bi-lobe.

La figure 3b représente la distribution de champ sur la courbe 33, et la distribution d'énergie sur la courbe 34 associées à l'émission de deux émetteurs 37 et 38 émettant en phase selon le mode symétrique, également dénommé mode fondamental. Ce mode est défini par une distribution de champs dans un plan perpendiculaire à la direction de propagation de l'onde optique pour laquelle le signe des maximas est invariant (++++). Ce mode ne présente aucun noeud (valeur nulle) de champ entre les N émetteurs, il existe donc une énergie non nulle du champ entre les émetteurs.

Afin de favoriser ce mode, la forme et l'agencement des rubans selon l'invention ont pour effet de briser la symétrie du dispositif comprenant les rubans parallèles, en décalant les guides selon une direction latérale x perpendiculaire à la direction des rubans, d'une distance D/2 et en les centrant sur l'ouverture du ruban suivant. Cet agencement permet au mode qui ne présente aucun noeud de champ entre les émetteurs, soit le mode fondamental, de se propager. De manière corrélative, cet agencement permet d'annihiler la propagation du mode antisymétrique, qui présente un champ nul entre les émetteurs. De manière générale, plus l'ordre du mode est élevé, c'est-à-dire plus le nombre de noeuds de champ est élevé, moins il sera favorisé, permettant au seul mode fondamental de se propager.

Ainsi, dans les zones 31 de propagation, les N émetteurs guidant l'onde optique sont parallèles, et les modes se propagent uniformément dans la direction y, sens de la longueur des rubans. Dans les zones de couplage 30, les rubans ont une extrémité 16 de forme effilée en pointe, et le long de la pointe, au fur et à mesure que la largeur du ruban diminue, le mode se délocalise et se couple sur les rubans situés à proximité, qui présentent le même motif en pointe. Lors de ce couplage, un filtrage du mode s'opère, favorisant le mode fondamental ou symétrique, au détriment du mode antisymétrique.

Ainsi le fait que chaque ruban du premier ensemble et chaque ruban du deuxième ensemble présente des extrémités en forme de pointe, en regard et inter digitée, permet de réaliser un filtrage entre les super modes du réseau de lasers par transfert adiabatique d'énergie. Au niveau des zones de couplage, il n'y pas d'échange d'énergie entre deux pointes mais une transformation adiabatique du super mode fondamental, sans réflexion ni perte optique, alors que les autres super modes qui ont eu le temps de s'établir dans les zones droites du laser (non inter digitées) subissent des pertes optiques car le changement modal n'est pas adiabatique.

Ce filtrage est d'autant plus efficace que les pointes sont longues et que le recouvrement est important, avec la limite que les pointes ne doivent pas constituer la majeure partie du ruban, c'est à dire la majeure partie du laser. D'autre part la forme en pointe, c'est-à-dire une diminution continue de la section jusqu'à une valeur la plus faible possible (compte tenu de la technologie) est une caractéristique essentielle pour que le filtrage s'opère. En effet, tout changement abrupt du profil romprait le transfert adiabatique et entraînerait une réflexion optique.

Des contraintes thermiques spécifiques aux QCL imposent que chaque zone active soit en contact avec un matériau intermédiaire, tel que défini précédemment, pour l'évacuation de la chaleur.

Pour les même raisons, la zone de filtrage doit être en contact avec le matériau intermédiaire, ce qui est réalisé par le dispositif selon l'invention, dans lequel chaque ruban, et donc sa pointe, est défini par la zone active. La pointe est donc « enterrée ».

Selon une variante, le dispositif selon l'invention comprend une pluralité de zones de couplage 30.

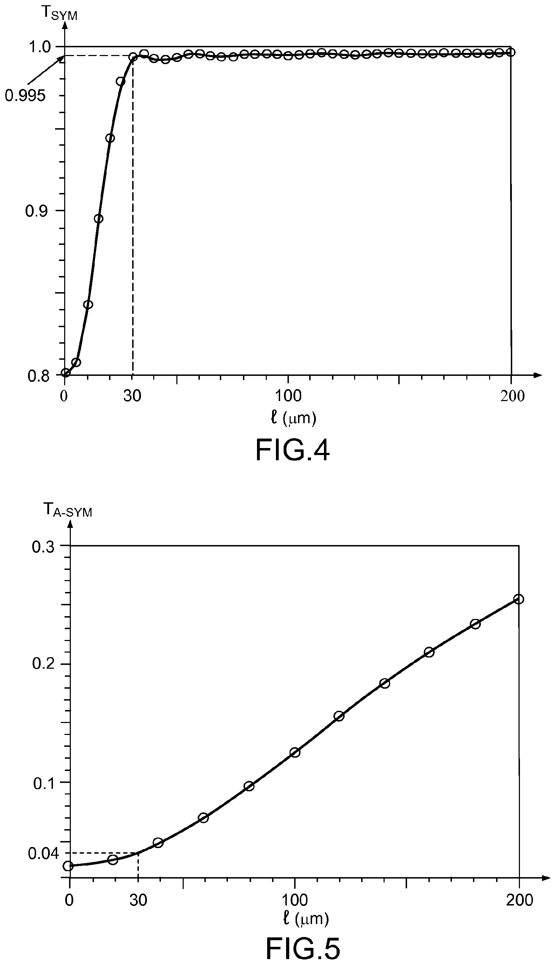

Les figures 4 et 5 décrivent à titre non limitatif une simulation d'un exemple de résultat obtenu avec un dispositif selon l'invention.

Pour cet exemple :

$\lambda$ = 8.4 $\mu$m ; D = 8 $\mu$m ; L = 2 $\mu$m ; d = 100% de la longueur l ; la structure active est un empilement GaInAs/Al/In/As, le substrat est InP.

On définit pour chaque mode un coefficient de transmission T. T est égal au maximum à 1 pour chaque mode. T correspond au rapport entre le champ à la sortie de la zone de coupage sur le champ à l'entrée de la zone de couplage. $T_{SYM}$ correspond au coefficient de transmission du mode fondamental ou symétrique, $T_{A\text{-}SYM}$ correspond au coefficient de transmission du mode asymétrique.

La figure 4 décrit l'évolution de $T_{SYM}$ en fonction de la valeur de l en $\mu$m. On constate qu'à partir de l>30 $\mu$m, $T_{SYM}$ est égal à 0.995. Le mode fondamental est transmis au passage de la zone de couplage 30. Le couplage du mode fondamental est très robuste par rapport à la valeur de la longueur l, $T_{SYM}$ restant constant sur la plage étudiée 30-200 $\mu$m.

La figure 5 décrit l'évolution corrélative de $T_{A\text{-}SYM}$ en fonction de la valeur de l en $\mu$m. On constate que la valeur de $T_{A\text{-}SYM}$ est faible comparé à la valeur de $T_{SYM.}$ Pour l=30 $\mu$m, $T_{A\text{-}SYM}$ = 0.04, et pour l=100 $\mu$m, $T_{A\text{-}SYM}$ est inférieur à 0.15.

La zone de couplage 30 selon l'invention opère bien comme un filtre qui favorise le mode fondamental au détriment du mode antisymétrique.

La figure 6 décrit un mode de réalisation du dispositif selon l'invention où chaque ruban 10 est défini par une structure active 62 uniquement, le dispositif étant vu en coupe selon le plan Oxz.

Dans ce cas la couche inférieure 61 et la couche supérieure 62 sont continues et disposées respectivement en dessous et au dessus des zones actives. La couche inférieure est disposée sur le substrat 60. Un matériau intermédiaire possédant de bonnes propriétés thermique et optique occupe les zones intermédiaires 64 situées entre deux structures actives 62. Avantageusement, sa conductivité thermique est supérieure à celle de la structure active, de manière à pouvoir évacuer l'énergie thermique générée par les structures actives. Le matériau intermédiaire est isolant ou semi-isolant électriquement, transparent optiquement pour la longueur d'onde d'émission laser, et son indice de réfraction est inférieur à celui de la structure active.

Par exemple le matériau intermédiaire est obtenu par épitaxie.

Un avantage de ce mode de réalisation est que la hauteur des zones intermédiaires 64 est égale à la hauteur de la structure active, soit par exemple environ $2\mu$m. Cette hauteur limitée facilite la croissance par épitaxie du matériau intermédiaire.

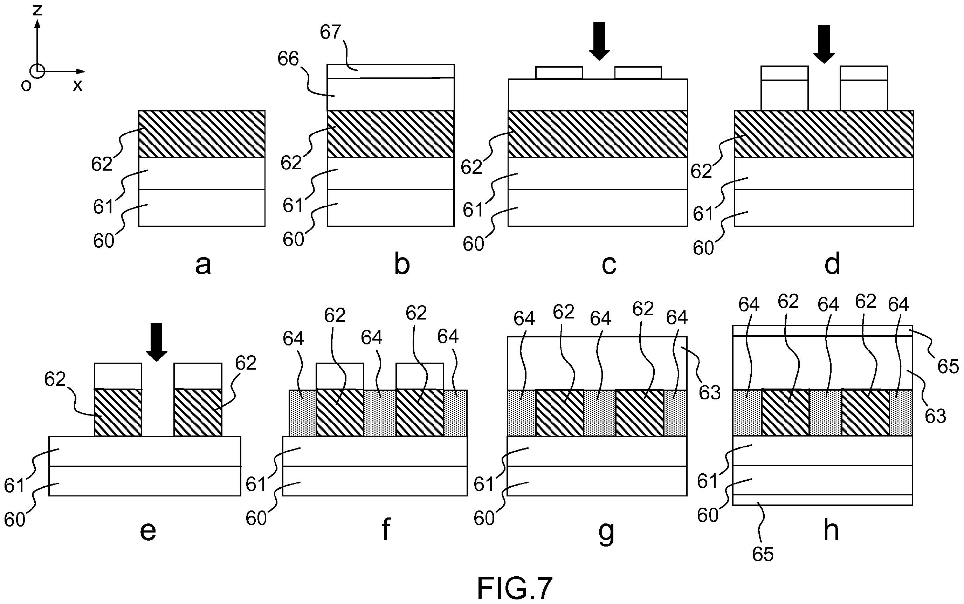

La figure 7 illustre schématiquement un exemple de procédé de fabrication du dispositif laser selon l'invention décrit figure 6, le dispositif étant vu en coupe selon le plan Oxz.

En 7a, la structure active 62 est initialement une couche continue composée d'une succession de plusieurs milliers de couches à base de GaInAs (puits) et de AlInAs (barrière), déposée sur la structure inférieure 61 par exemple en InP :Si, elle-même déposée sur un substrat 60, par exemple InP.

En 7b on dépose sur la structure active 62 une couche de SiO$_2$ 66 relativement épaisse (> 500 nm) et une couche de résine 67. Par lithographie optique le motif de guide en pointe est inscrit dans la résine en 7c.

Puis le motif est utilisé comme masque pour graver le SiO$_2$ en 7d puis la zone active en 7e, par gravure sèche ou RIE (pour « Reactive Ion Etching »). Les zones actives 62 ainsi fabriquées ont une forme de ruban avec des extrémités en forme de pointe. La gravure sèche permet d'obtenir une très bonne verticalité des flancs des rubans.

Puis la résine est enlevée. Dans l'étape 7f, le matériau intermédiaire est réalisé par épitaxie de manière à occuper les zones intermédiaires 64. Ce matériau est par exemple de l'InP dopé Fer (InP:Fe), qui possède un coefficient de conductivité thermique 10 fois supérieur à celui de la structure active 62.

Dans l'étape 7g, la couche de SiO$_2$ est enlevée par attaque chimique et la couche supérieure 63 est réalisée par épitaxie. La couche supérieure est par exemple également en InP :Si, comme la couche inférieure.

Dans l'étape 7h, on procède au dépôt des contacts 65, face avant et face arrière.

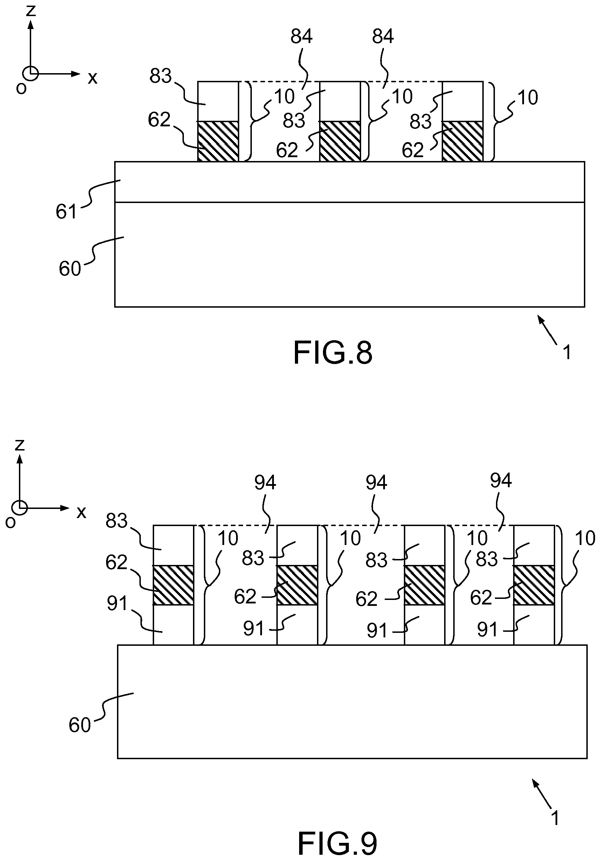

La figure 8 décrit un autre mode de réalisation du dispositif dans lequel le dispositif comprend une pluralité d'empilements comprenant une structure active 62 et une structure supérieure 83, chaque ruban 10 étant défini par un empilement. La couche inférieure 61 est continue.

Un matériau intermédiaire occupe les zones intermédiaires 84 entre les structures actives 62 ou entre les rubans 10.

La figure 9 décrit un autre mode de réalisation du dispositif dans lequel le dispositif comprend une pluralité d'empilements comprenant une structure inférieure 91, une structure active 62 et une structure supérieure 83, chaque ruban 10 étant défini par un empilement.

Un matériau intermédiaire occupe les zones intermédiaires 94 entre l'empilement comprenant une structure inférieure 91 et une structure active 62 ou entre les rubans 10.

Un avantage des modes de réalisation décrits sur les figures 8 et 9, où les structures inférieures et/ou supérieures contribuent à la définition des rubans, est une meilleure injection des porteurs dans la structure active.

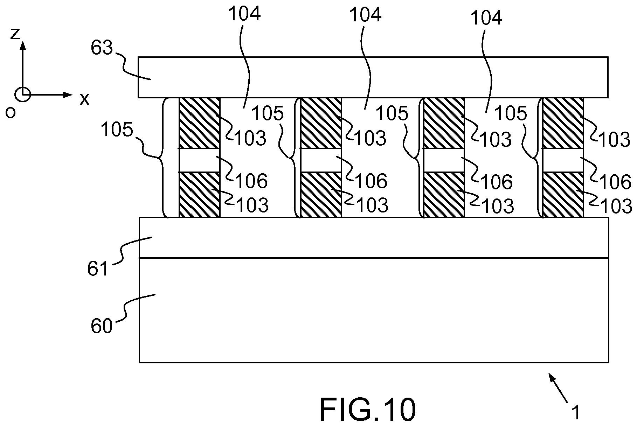

La figure 10 décrit une mode de réalisation de l'invention où la structure active 105 est multicouche, comprenant un empilement de couches actives 103, deux couches actives étant séparées par une couche de séparation 106 à base d'un matériau ayant une bonne conductivité thermique, au moins supérieure à la conductivité thermique d'une couche active, afin de réaliser une bonne évacuation de l'énergie thermique générée par les couches actives. Ce matériau est par exemple de l'InP:Si. Dans ce mode de réalisation, l'ensemble des couches actives contribuent à créer du gain.

Sur la figure 10, les rubans 10 sont définis par la structure active 105.

Alternativement, la structure active multicouche est compatible avec les modes de réalisation de l'invention décrits figure 8 et 9.

Avantageusement, un matériau intermédiaire occupe les zones intermédiaires 104 entre les rubans 10.

Un avantage de la structure active multicouche est que la présence d'une couche de séparation 106 permet une meilleure dissipation de la chaleur émise par les couches actives 103.

Avantageusement pour toutes les variantes des figures 6 à 10, la hauteur des zones intermédiaires 64, 84, 94 et 104 est supérieure ou égale à la hauteur des rubans 10, 105.

De manière générale, la géométrie en rubans permet une bonne évacuation de chaleur générée par la pluralité de structures actives, tandis que l'agencement spécifique des rubans opère un filtrage des modes optiques se propageant dans le dispositif, au profit du mode fondamental, permettant au dispositif selon l'invention d'émettre une lumière laser selon un faisceau unique autour d'une direction unique, soit un faisceau possédant de bonnes propriétés optiques ($M^2 \approx 1$).

**Revendications**

1. Dispositif (1) comprenant une pluralité de lasers semi-conducteurs à cascade quantique en réseau spatialement cohérents, comprenant :

   - une pluralité de structures actives (62, 105) disposées selon un plan (Oxy) et comprenant au moins une couche à gain apte à générer une onde optique présentant au moins une longueur d'onde d'émission (λ) et destinée à émettre lorsque des porteurs de charges sont injectés dans lesdites structures actives,

- chaque structure active comprenant un empilement de plusieurs centaines à plusieurs milliers de couches réalisant une alternance de couches définissant un puits quantique et de couches définissant une barrière quantique,

- chaque structure active étant disposée entre une structure supérieure et une structure inférieure déposée sur un substrat,

- lesdites structures supérieure et inférieure étant adaptées pour permettre l'injection de porteurs de charges dans lesdites structures actives et le confinement de ladite onde optique dans ledit plan (Oxy) et,

- ledit dispositif comprenant une pluralité de rubans (10) formant guides optiques et définis par au moins une structure active, lesdits rubans étant parallèles entre eux selon une direction d'alignement (y) comprise dans ledit plan (Oxy) et,

- un matériau intermédiaire occupe des zones intermédiaires (64, 84, 94, 104) entre deux rubans (10), ledit matériau intermédiaire présentant une conductivité thermique supérieure à la conductivité thermique d'une structure active,

**caractérisé en ce que** :

- chaque ruban (10) comprend au moins une première extrémité (16) en forme de pointe,

- ladite pluralité de rubans (10) est agencée selon au moins un premier ensemble (101) de rubans et au moins un deuxième ensemble (102) de rubans,

- deux rubans successifs d'un même ensemble sont espacés d'une distance de séparation (D) constante inférieure ou égale à ladite longueur d'onde d'émission ($\lambda$),

- lesdites extrémités en pointe (16) des rubans (10) du premier ensemble (101) étant orientées dans le sens opposé à celui desdites extrémités en pointe (16) des rubans (10) du deuxième ensemble (102) et pénétrant entre les extrémités en pointes (16) des rubans du deuxième ensemble (102) sur une distance de pénétration (d) définissant une première zone de couplage (30) par laquelle un mode fondamental de l'onde optique est transmis par couplage du premier ensemble de rubans (101) au deuxième ensemble de rubans (102).

2. Dispositif selon la revendication 1 dans lequel deux rubans successifs appartenant respectivement audit premier ensemble et audit deuxième ensemble sont espacés d'une distance de décalage ($\delta$) constante sensiblement égale à la moitié de ladite distance de séparation (D).

3. Dispositif selon les revendications 1 ou 2 dans lequel lesdits rubans (10) du deuxième ensemble (102) comprennent une deuxième extrémité (16) en forme de pointe coopérant avec des extrémités (16) en forme de pointe de rubans d'un troisième ensemble de rubans (203) de la même manière que les extrémités des rubans du premier ensemble (101) coopèrent avec les extrémités des rubans du deuxième ensemble (102), lesdites extrémités réalisant une deuxième zone de couplage (30) dans laquelle ledit mode fondamental de l'onde optique est transmis par couplage du deuxième ensemble de rubans (102) au troisième ensemble de rubans (103).

4. Dispositif selon la revendication 3 comprenant une série de N ensembles de rubans ayant chacun des extrémités en forme de pointe coopérant avec des extrémités en forme de pointe d'un autre ensemble pour définir des zones de couplage entre chaque ensemble.

5. Dispositif selon l'une des revendications précédentes dans lequel la structure inférieure (61) et la structure supérieure (63) sont continues et disposées respectivement en dessous et au dessus des structures actives (62).

6. Dispositif selon l'une des revendications 1 à 4 dans lequel chaque ruban (10) est défini par un empilement comprenant une structure active (62) et une structure supérieure (83).

7. Dispositif selon l'une des revendications 1 à 4 dans lequel chaque ruban (10) est défini par un empilement comprenant une structure inférieure (91), une structure active (62) et une structure supérieure (83).

8. Dispositif selon l'une des revendications précédentes dans lequel la structure active (105) comprend un empilement de couches actives (103), deux couches actives étant séparées par une couche de séparation (106) présentant une conductivité thermique supérieure à la conductivité thermique d'une couche active.

**Patentansprüche**

1. Vorrichtung (1), beinhaltend eine Vielzahl von räumlich vernetzten kohärenten Quantenkaskaden-Laser-Halbleitern, Folgendes beinhaltend:

- eine Vielzahl von aktiven Strukturen (62, 105), angeordnet in einer Ebene (Oxy) und beinhaltend mindestens eine Schicht mit Verstärkung, die in der Lage ist, eine optische Welle zu erzeugen, welche mindestens eine Emissionswellenlänge ($\lambda$) besitzt und dazu bestimmt ist, zu senden, wenn Ladungsträger in die aktiven Strukturen injiziert werden,

- wobei jede aktive Struktur einen Stapel von mehreren Hundert bis mehreren Tausend Schichten beinhaltet, welcher ein Alternieren von Schichten erzeugt, die eine Quantensenke definieren, und von Schichten, die eine Quantenbarriere definieren,

- wobei jede aktive Struktur zwischen einer oberen und einer unteren Struktur angeordnet ist, welche auf einem Substrat abgelagert ist,

- wobei die obere und untere Struktur geeignet sind, um die Injektion von Ladungsträgern in die aktiven Strukturen und den Einschluss der optischen Welle innerhalb der Ebene (Oxy) zu ermöglichen, und

- wobei die Vorrichtung eine Vielzahl von Bändern (10) beinhaltet, welche Lichtwellenleiter bilden und von mindestens einer aktiven Struktur definiert werden, wobei die Bänder parallel zueinander in einer Fluchtrichtung (y) in der Ebene (Oxy) sind, und

- ein Zwischenmaterial Zwischenbereiche (64, 84, 94, 104) zwischen zwei Bändern (10) ausfüllt, wobei das Zwischenmaterial eine Wärmeleitfähigkeit aufweist, welche höher ist als die Wärmeleitfähigkeit einer aktiven Struktur,

**dadurch gekennzeichnet, dass**:

- jedes Band (10) mindestens ein erstes Ende (16) in Form einer Spitze beinhaltet,
- die Vielzahl von Bändern (10) in mindestens einer ersten Gruppe (101) von Bändern und in mindestens einer zweiten Gruppe (102) von Bändern angeordnet ist,
- zwei aufeinander folgende Bänder einer selben Gruppe durch einen konstanten Trennabstand (D) voneinander getrennt sind, welcher kleiner als die bzw. gleich der Emissionswellenlänge (λ) ist,
- wobei die spitzen Enden (16) der Bänder (10) der ersten Gruppe (101) in die entgegengesetzte Richtung derjenigen Richtung weisen, in welche die spitzen Enden (16) der Bänder (10) der zweiten Gruppe (102) weisen, und zwischen die spitzen Enden (16) der Bänder der zweiten Gruppe (102) über einen Eindringabstand (d) ragen, welcher eine erste Kopplungszone (30) definiert, durch welche ein Grundmodus der optischen Welle durch Kopplung von der ersten Gruppe von Bändern (101) an die zweite Gruppe von Bändern (102) übertragen wird.

2. Vorrichtung nach Anspruch 1, bei welcher zwei aufeinander folgende Bänder, welche jeweils der ersten und der zweiten Gruppe angehören, durch einen konstanten Verschiebungsabstand (δ) voneinander getrennt sind, welcher im Wesentlichen die Hälfte des Trennabstandes (D) beträgt.

3. Vorrichtung nach Anspruch 1 oder 2, bei welcher die Bänder (10) der zweiten Gruppe (102) ein zweites Ende (16) in Form einer Spitze beinhalten, welches mit Enden (16) in Form von Spitzen von Bändern einer dritten Gruppe von Bändern (203) in derselben Weise zusammenarbeitet wie die Enden der Bänder der ersten Gruppe (101) mit den Enden der Bänder der zweiten Gruppe (102) zusammenarbeitet, wobei die Enden eine zweite Kopplungszone (30) bilden, in welcher der Grundmodus der optischen Welle durch Kopplung von der zweiten Gruppe von Bändern (102) an die dritte Gruppe von Bändern (103) übertragen wird.

4. Vorrichtung nach Anspruch 3, beinhaltend eine Serie von N Gruppen von Bändern, welche jeweils Enden in Form von Spitzen besitzen, welche mit Enden in Form von Spitzen einer anderen Gruppe zusammenarbeiten, um Kopplungszonen zwischen jeder Gruppe zu definieren.

5. Vorrichtung nach einem der vorhergehenden Ansprüche, bei welcher die untere Struktur (61) und die obere Struktur (63) durchgängig und jeweils unterhalb und oberhalb der aktiven Strukturen (62) angeordnet sind.

6. Vorrichtung nach einem der Ansprüche 1 bis 4, bei welcher jedes Band (10) durch einen Stapel definiert wird, beinhaltend eine aktive Struktur (62) und eine obere Struktur (83).

7. Vorrichtung nach einem der Ansprüche 1 bis 4, bei welcher jedes Band (10) durch einen Stapel definiert wird, beinhaltend eine untere Struktur (91), eine aktive Struktur (62) und eine obere Struktur (83).

8. Vorrichtung nach einem der vorhergehenden Ansprüche, bei welcher die aktive Struktur (105) einen Stapel von aktiven Schichten (103) beinhaltet, wobei zwei aktive Schichten durch eine Trennschicht (106) getrennt sind, welche eine höhere Wärmeleitfähigkeit als die Wärmeleitfähigkeit einer aktiven Schicht aufweist.

**Claims**

1. A device (1) comprising a plurality of spatially arrayed coherent quantum semiconductor lasers, comprising:

   - a plurality of active structures (62, 105) placed in a plane (Oxy) and comprising at least one gain layer able to generate an optical wave having at least one emission wavelength (λ) and intended to emit when charge carriers are injected into said active structures,

- each active structure comprising a stack of several hundreds to several thousands of layers embodying an alternation of layers defining a quantum well and layers defining a quantum barrier,

- each active structure being placed between an upper structure and a lower structure placed on a substrate,

- said upper and lower structures being adapted to allow the injection of charge carriers into said active structures and the containment of said optical wave in said plane (Oxy) and,

- said device comprising a plurality of stripes (10) forming optical guides and defined by at least one active structure, said stripes lying parallel to one another in an alignment direction (y) contained in said plane (Oxy) and,

- an intermediate material occupying the intermediate zones (64, 84, 94, 104) between two stripes (10), said intermediate material having a thermal conductivity greater than the thermal conductivity of an active structure,

**characterised in that**:

- each stripe (10) comprises at least one pointed first end (16),

- said plurality of stripes (10) is arranged in at least one first set (101) of stripes and at least one second set (102) of stripes,

- two consecutive stripes in the same set are spaced at a constant separation distance (D) less than or equal to said emission wavelength (λ),

- said pointed ends (16) of the stripes (10) of the first set (101) being orientated in the opposite direction to that of said pointed ends (16) of the stripes (10) of the second set (102) and penetrating between the pointed ends (16) of the stripes of the second set (102) over a penetration distance (d) defining a first coupling zone (30) via which a fundamental mode of the optical wave is transmitted via coupling of the first set of stripes (101) to the second set of stripes (102).

2. The device according to Claim 1, wherein two consecutive stripes belonging respectively to said first set and to said second set are spaced at a constant offset distance (δ) substantially equal to half of said separation distance (D).

3. The device according to Claim 1 or 2, wherein said stripes (10) of the second set (102) comprise a second pointed end (16) co-operating with the pointed ends (16) of stripes of a third set of stripes (203) in the same manner as the ends of the stripes of the first set (101) co-operating with the ends of the stripes of the second set (102), said ends embodying a second coupling zone (30) in which said fundamental mode of the optical wave is transmitted via coupling of the second set of stripes (102) to the third set of stripes (103).

4. The device according to Claim 3, comprising a series of N sets of stripes each having pointed ends co-operating with the pointed ends of another set to define coupling zones between each set.

5. The device according to any of the preceding claims, wherein the lower structure (61) and the upper structure (63) are continuous and placed respectively below and above the active structures (62).

6. The device according to any of the Claims 1 to 4, wherein each stripe (10) is defined by a stack comprising an active structure (62) and an upper structure (83).

7. The device according to any of the Claims 1 to 4, wherein each stripe (10) is defined by a stack comprising a lower structure (91), an active structure (62) and an upper structure (83).

8. The device according to any of the preceding claims, wherein the active structure (105) comprises a stack of active layers (103), two active layers being separated by a separation layer (106) having a thermal conductivity greater than the thermal conductivity of an active layer.

FIG.1

FIG.2

FIG.3a

FIG.3b

FIG.6

FIG.4

FIG.5

FIG.7

EP 2 856 588 B1

FIG.8

FIG.9

**FIG.10**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 4866724 A

- US 4722089 A

**Littérature non-brevet citée dans la description**

- **G.M. DE NAUROIS ; M. CARRAS ; B.SMOZRAG ; O. PATARD ; F. ALEXANDRE ; X. MARCADET.** Cohérent quantum cascade laser micro-stripe arrays. *AIP Advances,* 2011, vol. 1, 032165